# EUROPÄISCHE PATENTSCHRIFT

(11) **EP 1 455 391 B1**
(45) Veröffentlichungstag und Bekanntmachung des Hinweises auf die Patenterteilung: **21.03.2007**
(21) Anmeldenummer: 04003562.8
(22) Anmeldetag: 18.02.2004
(51) Int. Cl.: H01L 23/34

(54) **Leistungshalbleitermodul mit Sensorikbauteil**
Power semiconductor module with sensor
Module semiconducteur de puissance avec composant de détection

(30) Priorität: 04.03.2003 DE 10309302
(43) Veröffentlichungstag der Anmeldung: 08.09.2004
(73) Patentinhaber: SEMIKRON Elektronik GmbH & Co. KG, 90431 Nürnberg (DE)
(72) Erfinder: Stockmeier, Thomas, Dr., 90431 Nürnberg (DE)

(56) Entgegenhaltungen:
- EP-A- 0 888 036
- WO-A-02/054489
- DE-A- 10 024 516
- DE-A- 19 630 902
- DE-A- 19 920 401
- US-A- 5 721 455

## Beschreibung

Die Erfindung beschreibt ein Leistungshalbleitermodul mit einem oder mehreren Sensorikbauteilen. Moderne Leistungshalbleitermodule, die Ausgangspunkt dieser Erfindung sind, bestehen aus einem Gehäuse, mindestens einem darin angeordneten elektrisch isolierenden Substrat, welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Vorteilhafterweise weist das Substrat auf seiner Unterseite eine flächige metallische Schicht, vergleichbar den Verbindungsbahnen, auf. Zur Überwachung der Funktion derartiger Leistungshalbleitermodule weisen diese zunehmend Sensorikbauteile beispielhaft zur Temperaturüberwachung auf. Nach dem Stand der Technik sind verschiedene Anordnungen von Sensorikbauteilen innerhalb von Leistungshalbleitermodulen bekannt.

Verschiedene Ausgestaltungen derartiger Leistungshalbleitermodule mit hoher Leistung bezogen auf ihre Baugröße, die Ausgangspunkt dieser Erfindung sind, sind bekannt aus der DE 196 30 902 A1 oder der DE 100 24 516 A1.

Die DE 196 30 902 A1 offenbart beispielhaft ein Leistungshalbleitermodul der oben genannten Art. Hierbei ist ein Sensorikbauteil direkt auf einer Verbindungsbahn des Substrates angeordnet und mittels Drahtbondverbindungen mit nach außen führenden Anschlussleitern verbunden. Vorteilhaft an dieser Ausgestaltung ist, dass das Sensorikbauteil, hier ein Temperatursensor, unmittelbar benachbart zu den Leistungshalbleitbauelementen, deren Temperatur überwacht werden soll, angeordnet ist. Offen gelegt ist ein Silizium- Chipwiderstand als Temperatursensor, allerdings sind in vergleichbarer Anordnung auch andere Ausgestaltungen wie beispielhaft SMD Bauteile als Alternative bekannt.

Bei einer beispielhaft durch Überlastung ausgelösten Zerstörung des Leistungshalbleitermoduls kann das Sensorikbauteil und damit auch eine hiermit verbundene Auswerteschaltung mit Hochspannungspotential (bis zu einigen Kilovolt) beaufschlagt werden. Nachteilig an o.g. Leistungshalbleitermodulen nach dem Stand der Technik ist, dass im Falle eines gravierenden technischen Defektes, konkret einer Havarie, wie sie beispielhaft durch Explosion auf Grund einer Überlastung eintreten kann, das Sensorikbauteil an Hochspannungspotential liegen kann. Es können sich hierbei beispielhaft Drahtbondverbindungen der Leistungshalbleiterbauelemente teilweise lösen und in Kontakt mit dem Sensorikbauteil oder seinen Anschlussleitungen kommen und somit diese auf Hochspannungspotential legen. Dies hat den weiteren Nachteil, dass somit über die Anschlüsse des Sensorikbauteils auch die Auswerteschaltung auf dem Hochspannungspotential liegt.

Beispielhaft aus der DE 100 24 516 A1 sind weiterhin Leistungshalbleitermodule bekannt, bei denen das Sensorikbauteil, hier ebenfalls ein Temperatursensor, auf einem eigenen Substrat innerhalb des Leistungshalbleitermoduls angeordnet ist. Diese Anordnung ist im Havariefall nur dann vorteilhaft, wenn ein Kontakt mit dem Hochspannungspotential ausgeschlossen ist. Dies ist gewährleistet, falls das Substrat des Sensorikbauteil ausreichend von dem Hochspannungspotential aufweisenden Verbindungsbahnen beabstandet ist oder falls durch weitere ebenfalls in der DE 100 24 516 A1 offen gelegte Maßnahmen, wie beispielhaft eine Umhausung, das Sensorikbauteil von dem Hochspannungspotential räumlich getrennt angeordnet ist.

Nachteilig an der Ausgestaltung derartiger Leistungshalbleitermodule ist, dass mit den genannten wirkungsvollen Maßnahmen eine erhöhter Platzbedarf verbunden ist, der die nutzbare Fläche und damit direkt die Leistungsfähigkeit des Halbleitermoduls verringert. Weiterhin nachteilig ist, dass durch die genannten konstruktiven Maßnahmen der Fertigungsaufwand deutlich erhöht wird, und nur durch die räumliche Trennung ein Umhausung gewährleistet ist.

Der vorliegenden Erfindung liegt die Aufgabe zu Grunde ein Leistungshalbleitermodul mit mindestens einem Sensorikbauteil vorzustellen, wobei das Sensorikbauteil derart angeordnet ist, dass auch bei einem technischen Defekt bzw. einer Havarie des Leistungshalbleitermoduls ein im Leistungshalbleitermodul anliegendes Hochspannungspotential nicht an der Auswerteschaltung des Sensorikbauteils anliegt.

Diese Aufgabe wird gelöst durch eine Schaltungsanordnung nach dem Anspruch 1, spezielle Ausgestaltungen finden sich in den Unteransprüchen.

Der Grundgedanke der Erfindung geht aus von einem Leistungshalbleiterbauelement mit Grundplatte oder zur direkten Montage auf einem Kühlkörper nach dem genannten Stand der Technik bestehend aus einem Gehäuse mit mindestens einem darin angeordneten elektrisch isolierenden Substrat. Dieses Substrat besteht seinerseits aus einem Isolierstoffkörper mit einer Mehrzahl von auf seiner ersten Hauptfläche befindlichen gegeneinander isolierten metallischen Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden sind eine Mehrzahl von Leistungshalbleiterbauelementen angeordnet. Dem Leistungshalbleitermodul zugeordnet und direkt mit diesem verbunden ist mindestens ein Sensorikbauteil. Dieses Sensorikbauteil und / oder seine Montagefläche weist mit dem Kühlkörper oder der Grundplatte mindestens eine elektrisch leitende Verbindung auf. Weiterhin weist das Sensorikbauteil Anschlussleitungen zu einer Auswerteschaltung auf, wobei diese entweder direkt von diesem ausgehen, oder von diesem Sensorikbauteil zugeordneten Leiterbahn ausgehen.

Die Querschnittsfläche dieser leitenden Verbindung zum Kühlkörper oder zur Grundplatte muss derart ausgebildet sein, dass die auftretenden Ströme sicher zum Grundpotential abgeführt werden und nicht in die Auswerteschaltung gelangen.

Ein auf der zweiten dem Kühlkörper oder der Grundplatte zugewandten, nicht mit Leistungshalbleiterbauelementen bestückten, Hauptfläche des Substrates angeordnetes Sensorikbauteil erfüllt die gestellte Aufgabe in gleicher Weise. Vorteilhafterweise weist dieses Sensorikbauteil ebenfalls eine elektrisch leitende Verbindung zum Kühlkörper oder zur Grundplatte auf.

Die Erfindung wird anhand von Ausführungsbeispielen in Verbindung mit den Fig. 1 bis 5 näher erläutert.
- Fig. 1: zeigt die Anordnung eines Sensorikbauteils in einem Leistungshalbleitermodul nach dem Stand der Technik.
- Fig. 2: zeigt die Anordnung eines Sensorikbauteils auf der dem Kühlkörper abgewandten Seite eines erfinderischen Leistungshalbleitermoduls.
- Fig. 3: zeigt die Anordnung eines Sensorikbauteils auf der dem Kühlkörper zugewandten Seite eines erfinderischen Leistungshalbleitermoduls.
- Fig. 4: zeigt eine weitere Ausgestaltung eines erfinderischen Leistungshalbleitermoduls mit einem Sensorikbauteil auf der dem Kühlkörper zugewandten Seite.
- Fig. 5: zeigt ebenfalls eine Ausgestaltung eines erfinderischen Leistungshalbleitermoduls mit einem Sensorikbauteil auf der dem Kühlkörper zugewandten Seite.

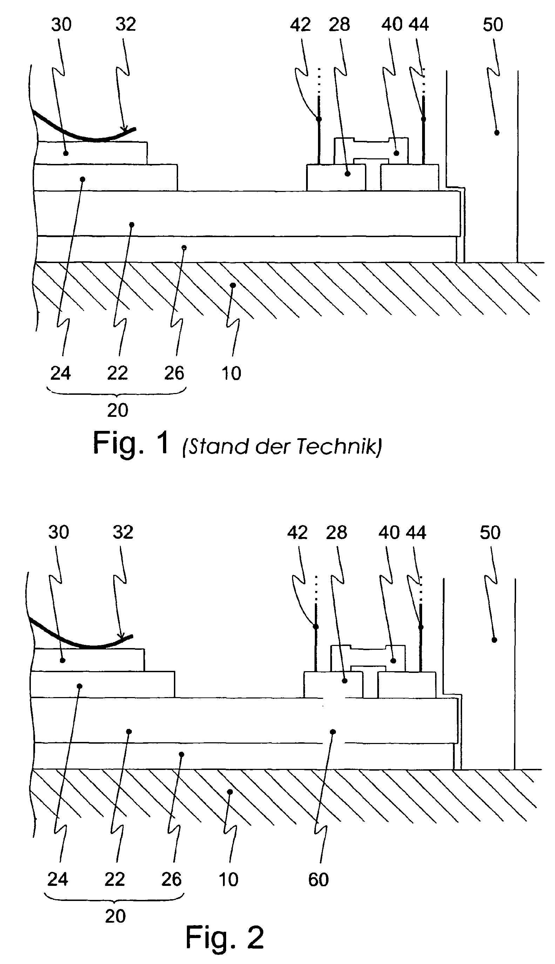

Fig. 1 zeigt eine Anordnung eines Sensorikbauteils in einem Leistungshalbleitermodul nach dem Stand der Technik. Dargestellt ist ein Leistungshalbleitermodul zur direkten Montage auf einem Kühlkörper (10), bestehend aus einem Gehäuse (50) und mindestens einem elektrisch isolierenden Substrat (20). Das Substrat seinerseits bestehend aus einem Isolierstoffkörper (22) mit einer Mehrzahl von auf seiner ersten dem Kühlkörper abgewandten Hauptfläche befindlichen gegeneinander isolierten metallischen Verbindungsbahnen (24). Auf seiner zweiten dem Kühlköper zugewandten Hauptfläche weist das Substrat eine den Verbindungsbahnen der ersten Hauptfläche gleichartige flächige Metallisierung (26) auf. Auf den Verbindungsbahnen (24) und mit diesen schaltungsgerecht mittels Drahtbondverbindungen (32) verbunden sind Leistungshalbleiterbauelemente (30). Auf weiteren Verbindungsbahnen (28) ist ein Sensorikbauteil (40), hier ein Temperatursensor, angeordnet. Dieser Temperatursensor (40) überwacht die Temperatur des Substrates (20) und damit die der Halbleiterbauelemente (30) mittels einer geeigneten Auswerteschaltung um damit das gesamte Leistungshalbleitermodul vor einer Zerstörung durch zu hohe Temperaturen während des Betriebes zu schützen. Weiterhin weist das Leistungshalbleitermodul elektrische Anschlussleitungen (42, 44) zur Verbindung der Leiterbahnen (28) auf denen der Temperatursensor (40) anordnet ist mit einer außerhalb des Leistungshalbleitermoduls angeordneten Auswerteschaltung auf.

Fig. 2 zeigt die Anordnung eines Sensorikbauteils auf der dem Kühlkörper abgewandten ersten Hauptfläche eines erfinderischen Leistungshalbleitermoduls, dessen prinzipieller Aufbau identisch ist dem Leistungshalbleitermodul nach Fig. 1. Das Sensorikbauteil (40) ist mittels der Anschlussleitungen (42, 44) mit einer extemen Auswerteschaltung verbunden. Erfinderisch an dieser Ausgestaltung des Leistungshalbleitermoduls ist die einen Flächenquerschnitt von mindestens 30mm² aufweisende Durchkontaktierung (60). Diese verbindet den auf Grundpotential liegenden Kühlkörper (10) über die Metallisierung (26) der zweiten Hauptfläche des Substrats mit einer Leiterbahn (28) und dem hierauf angeordneten Temperatursensor. Somit kann im Havariefall eine auftretende Verbindung zu Hochspannungspotential direkt mit dem Grundpotential verbunden werden. Auf Grund der ausreichend dimensionierten Durchkontaktierung wird ein Anliegen des Hochspannungspotentials an der Auswerteschaltung wirksam vermieden. Dies wird erreicht, indem das Hochspannungspotential führende Gebiet direkt mit dem Grundpotential verbunden wird.

Alternativ kann der Temperatursensor vergleichbar dem o.g. Stand der Technik auf einem eigenen, nicht mit Leistungshalbleiterbauelementen versehenen, Substrat angeordnet werden. Bei dieser Ausgestaltung ist allerdings ebenfalls zur Erfüllung der gestellten Aufgabe eine Durchkontaktierung oder eine äquivalente elektrische Verbindung mit dem Grundpotential vorzusehen.

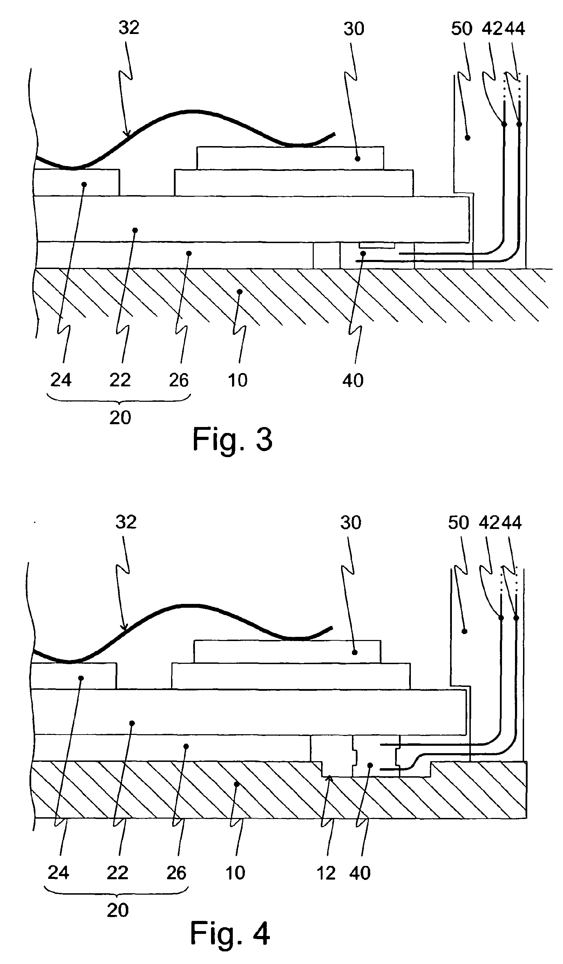

Fig. 3 zeigt die Anordnung eines Sensorikbauteils auf der dem Kühlkörper zugewandten zweiten Hauptfläche des erfinderischen Leistungshalbleitermoduls. Dargestellt ist hier wiederum ein Substrat (20), welches auf seiner ersten Hauptfläche Leiterbahnen (24) aufweist. Hierauf angeordnet und schaltungsgerecht mittels Drahtbondverbindungen (32) mit weiteren Leiterbahnen verbunden sind Leistungshalbleiterbauelemente (30). Auf der zweiten dem Kühlkörper zugewandten Hauptfläche des Substrates ist die Metallisierung (26) in einem definierten Bereich ausgespart. In diesem Bereich ist der Temperatursensor (40) direkt auf dem Isolierstoffkörper (22) angeordnet, vorteilhafterweise mittels einer Klebeverbindung hoher thermischer Leitfähigkeit. Die Anschlussleitungen (42, 44) zur Verbindung mit der Auswerteschaltung sind direkt mit dem Temperatursensor (40) verbunden und verlaufen im Inneren der Gehäusewandung (50). Vorteilhafterweise ist der Temperatursensor (40) mit seiner dem Substrat abgewandten Seite ebenfalls in thermisch leitendem Kontakt mit dem Kühlkörper (10). Eine Anordnung des Temperatursensors auf der zweiten Hauptfläche des Substrates (20) ist dahingehend vorteilhaft, da hierdurch kein Platz auf der ersten Hauptfläche benötigt wird und diese somit für die Anordnung von Leistungshalbleiterbauelementen (30) zu Verfügung steht.

Fig. 4 zeigt eine weitere abgewandelte Ausgestaltung eines erfinderischen Leistungshalbleitermoduls mit einem Sensorikbauteils (40). Dieses ist mit seiner ersten dem Substrat zugewandten Montagefläche auf der zweiten Hauptfläche des Isolierstoffkörpers (22) des Substrates (20) angeordnet. Gezeigt ist hier ein Leistungshalbleitermodul mit Grundplatte (10), wobei diese Grundplatte (10) ein Ausnehmung (12) aufweist, die ausreichend dimensioniert ist, um einen Temperatursensor (40) aufzunehmen, der eine größere vertikale Ausdehnung als die Metallisierung (26) aufweist. Die zweite der Grundplatte zugewandte Montagefläche des Sensorikbauteils ist direkt und elektrisch leitend auf der Grundplatte (10) angeordnet.

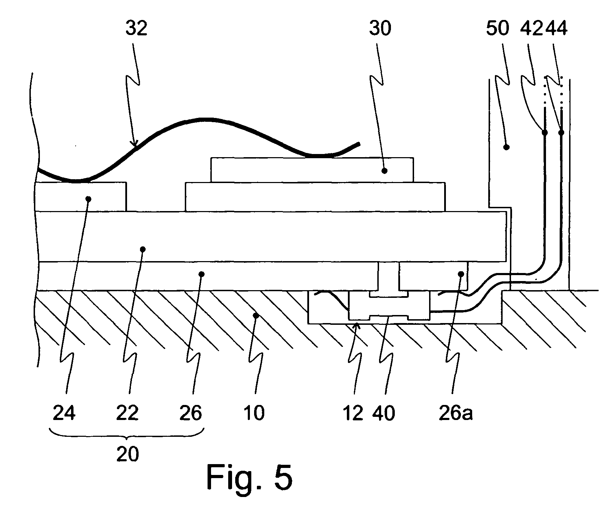

Fig. 5 zeigt ebenfalls ein Ausgestaltung eines erfinderischen Leistungshalbleitermoduls mit einem Sensorikbauteils auf der dem Kühlkörper (10) zugewandten Seite. Hierbei weist der Kühlkörper (10) eine Aussparung (12) auf. Das Substrat weist hierbei auf seiner zweiten Hauptfläche eine weitere Metallisierung (26a) auf. Der Temperatursensor ist schaltungsgerecht auf den beiden Metallisierung (26, 26a) der zweiten Hauptfläche angeordnet. Die Anschlussleitungen (42, 44) sind ebenfalls mit diesem beiden Metallisierungen verbunden. Die Aussparung (12) des Kühlkörpers (10) ist derart angeordnet und dimensioniert, dass der Sensor und dessen Anschlussleitungen (42, 44) nicht mit dem Kühlkörper in Kontakt sind. Die thermisch Anbindung besteht über die Metallisierungen des Substrates. Die Anordnung des Temperatursensors erfolgt hier mittels Löt- oder Klebeverbindung.

Bei den in den Fig. 3 bis 5 beschrieben Anordnungen des Sensorikbauteils (40) auf der zweiten Hauptfläche des Substrates (20) ist auch im Havariefall ausgeschlossen, dass Hochspannungspotential mit dem Sensorikbauteil und / oder seinen Anschlussleitungen in Kontakt kommt.

## Patentansprüche

1. Leistungshalbleitermodul mit Grundplatte (10) oder zur direkten Montage auf einem Kühlkörper (10), bestehend aus einem Gehäuse (50), mindestens einem elektrisch isolierenden Substrat (20), seinerseits bestehend aus einem Isolierstoffkörper (22) mit einer auf seiner ersten dem Kühlkörper oder der Grundplatte abgewandten Hauptfläche befindlichen Mehrzahl von gegeneinander isolierten metallischen Verbindungsbahnen (24), darauf befindlichen und mit diesen Verbindungsbahnen schaltungsgerecht verbundenen Leistungshalbleiterbauelementen (30) und mindestens einem Sensorikbauteil (40), das Anschlussleitungen (42, 44) zu einer außerhalb des Leistungshalbleitermoduls angeordneten Auswerteschaltung aufweist,
**dadurch gekennzeichnet, dass**
das Sensorikbauteil (40) und / oder dessen Montagefläche zu dem Kühlkörper (10) oder der Grundplatte (10) mindestens eine elektrisch leitende Verbindung (60) aufweist.

2. Leistungshalbleitermodul mit Grundplatte (10) oder zur direkten Montage auf einem Kühlkörper (10), bestehend aus einem Gehäuse (50), mindestens einem elektrisch isolierenden Substrat (20), seinerseits bestehend aus einem Isolierstoffkörper (22) mit einer auf seiner ersten dem Kühlkörper oder der Grundplatte abgewandten Hauptfläche befindlichen Mehrzahl von gegeneinander isolierten metallischen Verbindungsbahnen (24), darauf befindlichen und mit diesen Verbindungsbahnen schaltungsgerecht verbundenen Leistungshalbleiterbauelementen (30) und mindestens einem Sensorikbauteil (40), das Anschlussleitungen (42, 44) zu einer außerhalb des Leistungshalbleitermoduls angeordneten Auswerteschaltung aufweist,
**dadurch gekennzeichnet, dass**
das Sensorikbauteil (40) auf der zweiten dem Kühlkörper oder der Grundplatte zugewandten Hauptfläche des Substrates (20) angeordnet ist.

3. Leistungshalbleitermodul nach Anspruch 1, wobei
das Sensorikbauteil (40) auf Leiterbahnen (24) der ersten Hauptfläche des Substrates (20) angeordnet ist und eine dieser Leiterbahnen eine elektrisch leitende Verbindung (60) zur auf der zweiten Hauptfläche angeordneten Metallisierung (26) und über diese zum Kühlkörper (10) oder zur Grundplatte (10) aufweist.

4. Leistungshalbleitermodul nach Anspruch 1, wobei
die elektrisch leitende Verbindung (60) zum Kühlkörper (10) oder zur Grundplatte (10) mindestens einen Querschnitt von 30mm² aufweist.

5. Leistungshalbleitermodul nach Anspruch 1, wobei
das Sensorikbauteil (40) auf einem eigenen Substrat angeordnet ist.

6. Leistungshalbleitermodul nach Anspruch 2, wobei
das Sensorikbauteil (40) auf strukturierten Leiterbahnen (26, 26a) der zweiten Hauptfläche des Substrates (20) oder direkt auf dieser Hauptfläche angeordnet ist und eine elektrisch leitende Verbindung zum Kühlkörper (10) oder zur Grundplatte (10) aufweist.

## Claims

1. A power semiconductor module comprising a baseplate (10) or for the direct installation on a cooling body (10), consisting of a housing (50), at least one electrically insulating substrate (20) consisting, on its part, of an insulation body (22) comprising a plurality of mutually insulated metallic connecting strips (24) located on its first main surface facing away from the cooling body or the base plate, power semiconductor components (30) located thereon and being connected with said connecting strips in a circuit-based manner and at least one sensor component (40) encompassing connecting leads (42, 44) to an evaluation circuit arranged outside of the power semiconductor module,
**characterized in that**
the sensor component (40) and/or its installation surface comprise at least one electrically conducting connection (60) to the cooling body (10) or to the baseplate (10).

2. The power semiconductor module comprising a baseplate (10) or for the direct installation on a cooling body (10), consisting of a housing (50), at least one electrically insulating substrate (20) consisting, on its part, of an insulation body (22) comprising a plurality of mutually insulated metallic connecting strips (24) located on its first main surface facing away from the cooling body or the base plate, power semiconductor components (30) located thereon and being connected with said connecting strips in a circuit-based manner and at least one sensor component (40) encompassing connecting leads (42, 44) to an evaluation circuit arranged outside of the power semiconductor module,
**characterized in that**
the sensor component (40) is arranged on the second main surface of the substrate (20) facing the cooling body or the baseplate.

3. The power semiconductor component according to claim 1, with the sensor component (40) being arranged on strip conductors (24) of the first main surface of the substrate (20) and one of said strip conductors encompassing an electrically conducting connection (60) to the metallization (26) arranged on the second main surface and to the cooling body (10) or to the base plate (10) via said metallization (26).

4. The power semiconductor module according to claim 1, with the electrically conducting connection (60) to the cooling body (10) or to the baseplate (10) comprising at least a cross section of 30 mm².

5. The power semiconductor module according to claim 1, with the sensor component (40) being arranged on its own substrate.

6. The power semiconductor module according to claim 2, with the sensor component (40) being arranged on structured strip conductors (26, 26a) of the second main surface of the substrate (20) or directly on said main surface and comprising an electrically conductive connection to the cooling body (10) or to the baseplate (10).

## Revendications

1. Module semi-conducteur de puissance avec plaque de base (10) ou pour le montage direct sur un refroidisseur (10), constitué d'un boîtier (50), d'au moins un substrat isolant électrique (20), lui-même constitué d'un corps isolant (22) avec plusieurs pistes de liaison (24) métalliques isolées les unes des autres et situées sur sa première surface principale éloignée du refroidisseur ou de la plaque de base, avec des composants semi-conducteurs de puissance (30) placés dessus et reliés à ces pistes de liaison conformément au circuit et avec au moins un composant capteur (40) qui comporte des lignes de raccordement (42, 44) vers un circuit d'évaluation disposé en dehors du module semi-conducteur de puissance,
**caractérisé par le fait que** le composant capteur (40) et/ou sa surface de montage comporte au moins une liaison électriquement conductrice (60) vers le refroidisseur (10) ou vers la plaque de base (10).

2. Module semi-conducteur de puissance avec plaque de base (10) ou pour le montage direct sur un refroidisseur (10), constitué d'un boîtier (50), d'au moins un substrat isolant électrique (20), lui-même constitué d'un corps isolant (22) avec plusieurs pistes de liaison (24) métalliques isolées les unes des autres et situées sur sa première surface principale éloignée du refroidisseur ou de la plaque de base, avec des composants semi-conducteurs de puissance (30) placés dessus et reliés à ces pistes de liaison conformément au circuit et avec au moins un composant capteur (40) qui comporte des lignes de raccordement (42, 44) vers un circuit d'évaluation disposé en dehors du module semi-conducteur de puissance,
**caractérisé par le fait que** le composant capteur (40) est disposé sur la deuxième surface principale du substrat (20) tournée vers le refroidisseur ou vers la plaque de base.

3. Module semi-conducteur de puissance selon la revendication 1, dans lequel le composant capteur (40) est disposé sur des pistes conductrices (24) de la première surface principale du substrat (20) et l'une de ces pistes conductrices comporte une liaison électriquement conductrice (60) vers la métallisation (26) disposée sur la deuxième surface principale et par l'intermédiaire de cette métallisation vers le refroidisseur (10) ou vers la plaque de base (10).

4. Module semi-conducteur de puissance selon la revendication 1, dans lequel la liaison électriquement conductrice (60) vers le refroidisseur (10) ou vers la plaque de base (10) a au moins une section transversale de 30 mm².

5. Module semi-conducteur de puissance selon la revendication 1, dans lequel le composant capteur (40) est disposé sur un substrat particulier.

6. Module semi-conducteur de puissance selon la revendication 2, dans lequel le composant capteur (40) est disposé sur des pistes conductrices structurées (26, 26a) de la deuxième surface principale du substrat (20) ou directement sur cette surface principale et comporte une liaison électriquement conductrice vers le refroidisseur (10) ou vers la plaque de base (10).
